# EUROPEAN PATENT APPLICATION

(11) **EP 4 679 312 A1**
(43) Date of publication of application: **14.01.2026**
(21) Application number: 24187154.0
(22) Date of filing: 08.07.2024
(51) Int. Cl.: G06F 30/30, G06F 30/327, G06F 30/34

(54) **IMPROVED CIRCUIT IMPLEMENTATION**

(71) Applicant: Sigasi, 9050 Gent (BE)
(72) Inventor: Medina Ospina, David, 9050 Gent (BE); Lemiengre, Lieven, 9050 Gent (BE); Christiaens, Mark, 9050 Gent (BE)
(74) Representative: Patentales BV

(57) **Abstract**

The invention provides, amongst other aspects, a computer-implemented method of reconfiguring an incomplete project for implementation of a circuit into a complete project for implementation of the circuit, the at least part of a project comprising incomplete hardware description language, HDL, files, the complete project comprising complete HDL files, the method comprising: obtaining the incomplete HDL files comprising a respective HDL code, identifying symbols, preferably identifiers, in the respective HDL code, determining constraints based on the identified symbols, preferably identifiers, and reconfiguring the incomplete HDL files based on the constraints to obtain the complete HDL files, wherein the reconfiguring of the incomplete HDL files comprises determining a mapping of the incomplete HDL files to a respective library, wherein the mapping relates to solving a satisfiability problem to satisfy the constraints.

## Description

### Field of the invention

The present invention relates to the technical domain of circuit implementation, particularly reconfiguring an incomplete project for implementation of a circuit into a complete project for implementation of the circuit, the incomplete project comprising incomplete hardware description language, HDL, files and the complete project comprising complete HDL files.

### Background art

Advances in process technology and an increasing demand for computing and storage have fueled an increase in the size and complexity of integrated circuit (IC) designs. Circuit designs may be described in a project using one or more hardware definition languages (HDLs) which can be used to describe the functionality of an IC design. In circuit design, an Integrated Development Environment (IDE) is typically used, which refers to a software suite that provides tools for designing, developing, simulating, and verifying digital logic designs, such as FPGA (Field-Programmable Gate Array), ASIC (Application-Specific Integrated Circuit) or mixed-signal circuit chips. The IDE can allow designers to create, test, optimize, and manufacture digital logic designs.

Choosing or changing an IDE can be driven by various reasons, such as to make use of features or advanced capabilities, intuitive HDL code editing, debugging tools, and the integration with external tools.

The complexity of circuit designs often results in large projects. Even within a single business entity, a project is shared by multiple designers in different teams, each for a particular part of the circuit design. Typically, there is no standard for defining a project. Therefore, different definitions are often used by different designers and/or teams. Thus, this could create issues when combining all the files in the project. This is particularly prevalent when importing a pre-existing project into a new IDE due to the diversity of project definition. Thus, since the definitions of the project are designer-specific, the new IDE would be unable to simulate, synthesize, and implement the circuit design. This can result in uncertainties in the manufacturing of the circuits and the performance of the circuits after manufacturing. Thus, there is a need to ensure that the circuits are robustly designed and can eventually be manufactured into functioning and robust circuits.

These challenges highlight the need for improved methods that can overcome these limitations.

The present invention aims at addressing issues, such as the issues mentioned above.

### Summary of the invention

According to a first aspect, the present invention provides a (computer-implemented) method for reconstructing and/or reconfiguring a (circuit design) project, preferably for implementation of a circuit, into a complete project, preferably for implementation of the circuit, the incomplete project comprising incomplete hardware description language, HDL, files, the complete project comprising complete HDL files, the method comprising:
- obtaining the incomplete HDL files comprising a respective HDL code,
- identifying symbols, preferably identifiers, in the respective HDL code,
- determining constraints based on the identified symbols, preferably identifiers, and
- reconstructing and/or reconfiguring the incomplete HDL files based on the constraints to obtain complete HDL files,

wherein the reconstructing and/or reconfiguring of the incomplete HDL files comprises determining a mapping of the identified symbols, preferably identifiers, more preferably the incomplete HDL files, to a respective namespace,
preferably wherein the mapping may relate to solving a satisfiability problem to satisfy the constraints.

According to another aspect, the present invention provides a method of reconstructing and/or reconfiguring an incomplete project for simulation of a circuit into a complete project for simulation of the circuit.

By reconstructing and/or reconfiguring the incomplete HDL files and/or the incomplete project, the method may advantageously ensure that all elements of the project are well-defined, which promotes design reusability and consistency across different teams and project definitions and may additionally enable better integration and verification of design elements within the digital or circuit design. This may ensure that at least part (i.e., the incomplete part), preferably all aspects, of the project are accounted for, which can improve overall design quality and accuracy. Thus, the risk of design errors and inconsistencies that can arise from incomplete information is reduced.

It will be understood that the method is itself to be regarded as a modern technical method which forms an essential part of the fabrication process of a technical product or a physical product (e.g., a digital circuit and/or an integrated circuit) and precedes actual production or manufacturing, mostly as an intermediate step. The reconstructing and/or reconfiguring of the incomplete HDL files, preferably the reconstructing and/or reconfiguring of the incomplete project are specifically adapted for an intended technical use, particularly intended for manufacturing the technical product or the physical product, and as a result, the technical effect of the reconstructing and/or reconfiguring of the incomplete HDL files, preferably the reconstructing and/or reconfiguring of the incomplete project is to be considered implied by the method according to the present invention.

In embodiments, the method further comprises generating instructions for manufacturing the circuit based on the complete HDL files, preferably based on the complete project, wherein said manufacturing preferably relates to producing of an ASIC or to programming of an FPGA. Therefore, the complete HDL files, preferably the complete project may be provided to a manufacturing means for manufacturing a digital circuit and/or an integrated circuit as instructions for manufacturing. Thus, it will be understood that the outlay for implementing the technical product or physical product can increasingly shift to the digital design phase.

According to a second aspect, the present invention provides a device comprising means for carrying out the method according to the invention.

According to a third aspect, the present invention provides a system comprising the device according to the invention and a user apparatus comprising a display and being connected to the device, wherein the device is configured to perform the steps of:
- obtaining, from the user apparatus, the incomplete HDL files comprising a respective HDL code,
- identifying symbols, preferably identifiers, in the respective HDL code,
- determining constraints based on the identified symbols, preferably identifiers, and
- reconstructing and/or reconfiguring the incomplete HDL files based on the constraints to obtain complete HDL files,
wherein the user apparatus is configured to perform the following steps:
- providing, to the device, the incomplete HDL files comprising a respective HDL code, and
- obtaining, from the device, the complete HDL files,

wherein the reconstructing and/or reconfiguring of the incomplete HDL files comprises determining a mapping of the identified symbols, preferably identifiers, preferably the incomplete HDL files, to a respective namespace,
preferably wherein the mapping may relate to solving a satisfiability problem to satisfy at least most of the constraints.

The system may be suitable for reconfiguring an incomplete project for implementation of a circuit into a complete project for implementation of the circuit, the incomplete project, wherein the incomplete project comprises the incomplete HDL files and the complete project comprises the compete HDL files. Such a system may advantageously ensure that all elements of the project are well-defined, which promotes design reusability and consistency across different teams and project definitions and may additionally enable better integration and verification of design elements within the digital or circuit design.

According to a fourth aspect, the present invention provides a computer program comprising instructions which, when the program is executed by a computer, cause the computer to carry out the method according to the invention. The computer program product may comprise at least one readable medium in which computer-readable program code portions are saved, which program code portions comprise instructions for carrying out said method.

According to a fifth aspect, the present invention provides a computer-readable medium comprising instructions which, when executed by a computer, cause the computer to carry out the method according to the invention.

Preferred embodiments and their advantages are provided in the description and the dependent claims.

### Brief description of the drawings

The present invention will be discussed in more detail below, with reference to the attached drawings.
Fig. 1 shows a first example method according to the invention.
Fig. 2 shows a second example method according to the invention.

### Description of embodiments

The following descriptions depict only example embodiments and are not considered limiting in scope. Any reference herein to the disclosure is not intended to restrict or limit the disclosure to exact features of any one or more of the exemplary embodiments disclosed in the present specification.

Furthermore, the terms first, second, third and the like in the description and in the claims are used for distinguishing between similar elements and not necessarily for describing a sequential or chronological order. The terms are interchangeable under appropriate circumstances and the embodiments of the invention can operate in other sequences than described or illustrated herein.

Furthermore, the various embodiments, although referred to as "preferred" are to be construed as exemplary manners in which the invention may be implemented rather than as limiting the scope of the invention.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present invention, the only enumerated components of the device are A and B, and further the claim should be interpreted as including equivalents of those components.

In this document, the term "simulation" concerns running hardware description language code comprising the description of electronic circuits at different levels of abstraction. The simulation may comprise at least one of the following: translating (e.g., by an HDL compiler) the high-level HDL code into lower-level netlists or gate-level descriptions that can be understood by a simulator; analyzing (e.g., by the simulator) the netlist to determine at least one of: the circuit's behavior under different input conditions, time steps, and environmental factors (like temperature or power supply voltage); calculating (e.g., by the simulator) outputs based on at least one of: the inputs, internal logic functions, and timing information in the digital design; displaying the simulation results in a waveform viewer or other graphical representation, allowing engineers to visualize at least one of: input-output relationships, timing relationships between signals, and other important performance metrics. The simulation can be used for various purposes like functional verification, timing analysis, power analysis, and design optimization. The simulator and/or the design engineer can identify potential issues in the design before actual hardware implementation, saving time and resources. After identifying any design issues or errors, the simulator may propose and/or the engineer may make corrections to the HDL code and repeat the simulation process until the desired functionality, performance, and power consumption are achieved.

Herein the term "circuit" may refer to any electronic component or programmable device, such as a digital circuit or an integrated circuit, and is used interchangeably with the term "(circuit) design" or the likes, such as "digital design".

The term "implementation" concerns converting the high-level HDL code into physical circuits. The process may involve synthesizing before physically implementing the project, particularly the digital logic described in the HDL files comprised in the project. The implementation may be performed using field-programmable gate arrays (FPGAs) and/or application-specific integrated circuits (ASICs). The synthesizing may comprise converting the high-level HDL code into a lower-level representation, such as low-level digital building blocks (e.g., logic gates and/or flip-flops), e.g., using an electronic design automation (EDA) tool.

The term "namespace" refers to a (logical) container for symbols that provides a scope and naming to declarations made inside it. It can help in organizing and managing symbols used in an HDL code and can prevent naming conflicts between different elements in HDL code, allowing unique access to the elements based on their namespace. A symbol may comprise at least one of: an identifier, an operator, a literal, a special character, etc. The term "identifier" may be any one of: a number, a Unicode sequence, an emoticon, an icon, an ASCII, or a symbol, such as a label or a name, for identifying elements in an HDL code. The identifier may refer to any element that is or has been declared, e.g., within the project. The identifier may relate, e.g., may be a handle for accessing or referring, to at least one of the following elements or constructs: at least one signal, at least one variable, at least one function, at least one type, at least one type alias, at least one constant, at least one procedure, at least one task, at least one port, at least one interface, at least one (discrete logic and/or analog) circuit, at least one block, at least one parameter, etc. The term "operator" refers to a symbol that represents a mathematical and/or logical operation, such as an arithmetic operator, a logic operator, a relational operator, a bitwise operator, and an assignment operator, and performs specific operations when used with operands in expressions. The term "literal" refers to a fixed value assigned to constants, input/output ports, or initial values for signals in HDL code and may be a number (binary, decimal, octal, hexadecimal), a string, a character, a decimal, or any other form of constant data. The term "special character" refers to a symbol that has a specific meaning within the HDL code and may define a structure, control flow, and any other aspect of the HDL code, such as parentheses, curly braces, semicolon, and comments. In embodiments, the reconfiguring of the incomplete HDL files comprises determining a mapping of the identified symbol, preferably the identified identifier, to a respective namespace.

The term "library" refers to a (physical) collection of reusable design elements and/or identifiers that can be shared and used across different HDL files. Each design element may define its own set of symbols. A design element may comprise at least one of: at least one module, at least one macro, at least one testbench, at least one entity, at least one architecture, at least one component, at least one package, at least one configuration, etc. A library may contain, among other, declaration of design elements and/or identifier. When a library is in a project, a declaration made inside a design element is brought into the current design's scope for use, that design element can be included in a library for reuse. In this sense, a library may include the at least one declaration from at least one namespace. In embodiments, a library may be a namespace. In embodiments, the reconfiguring of the incomplete HDL files comprises determining a mapping of the identified symbol, preferably the identified identifier, to a respective library or namespace. An entity may define or comprise at least one of: ports (e.g., input and output interfaces with specified data types and directions) and architecture pointers (e.g., references to architectures within the entity), etc. An architecture (behavioral) may define or comprise at least one of: signals (e.g., logical or numerical signals used for communication between processes, components, or other design elements), variables (e.g., memory elements with specified data types and sizes), constants (e.g., named values with fixed values that cannot be changed during simulation or synthesis), types and type aliases (e.g., user-defined data types for use in the architecture), functions (e.g., subprograms that return a value based on input arguments), procedures (e.g., subprograms without a return value, typically used for side effects or control flow manipulation), tasks (e.g., concurrent subroutines executed asynchronously with other processes and procedures), and processes (e.g., sequential blocks of code that execute in response to specific events or continuously during simulation or synthesis), etc. An architecture (structural) may define or comprise at least one of: components (e.g., instantiated design elements, such as entities, architectures, or components), representing physical or logical building blocks and ports (e.g., interfaces for communication between the architecture and instantiated components), etc. A package may define or comprise at least one of: constants (e.g., named values that can be used across multiple design elements within a project), types and type aliases (e.g., user-defined data types for use across multiple design elements), functions (e.g., subprograms with shared functionality, often used to implement common algorithms or mathematical expressions), and procedures (e.g., subprograms without a return value, typically used for shared control flow manipulation or initialization tasks), etc. A component may define or comprise at least one of: ports (e.g., input and output interfaces for communication with the architecture that instantiates the component) and internally defined signals, variables, constants, types, functions, and procedures (e.g., used to implement the functionality of the component), etc. A testbench may define or comprise at least one of: processes (e.g., initial process, stimulus process, checker process), variables (e.g., input variables, output variables), constants (e.g., input constants and time constants), signals (e.g., clock signals), procedures (e.g., for simulating testbench structures, controlling stimulus generation, and handling simulation events), etc.

The term "HDL code" refers to a textual description of digital designs (e.g., digital circuit designs) written using a hardware description language (HDL) like VHSIC HDL (VHDL) or (System) Verilog. Other HDLs will be understood by a person skilled in the art. The HDL code may describe at least one of: functionality, structure, behavior, and interconnection of digital systems at various levels of abstraction (e.g., register transfer level, gate level). The code may be used for at least one of: simulating and/or validating the digital design's functionality, synthesizing the digital design into a hardware implementation, testbench and/or verification intellectual property (IP), and generating documentation or instructions for manufacturing or verification purposes. Testbench refers to HDL code that is used to simulate and test digital designs, e.g., Device Under Test (DUT). Verification IP refers to pre-designed, verified IP cores that are specifically used for functional verification of digital designs during simulation.

The term "HDL file" refers to a text file which comprises HDL code written in an HDL, such as VHDL and/or (System) Verilog and/or SystemC, which may describe the functionality, structure, and behavior of a digital (circuit) design. The digital design may relate to a circuit, as described herein, such as a digital system (e.g., logic gates, flip-flops, registers, logic blocks), a microprocessor and/or a digital signal processor, memory (e.g., SRAM, DRAM, etc.) power system (e.g., power supply, voltage regulator, etc.), communication system (e.g., digital modem, wireless transceiver, etc.), etc. The HDL file may comprise at least one of: at least one source file, at least one testbench file and at least one configuration file. A source file may comprise an HDL code and a configuration file may comprise configuration parameters (e.g., library declaration and/or library mapping, HDL level, pre-processing configuration, HDL file dependency and/or hierarchy). Alternatively, the source file may comprise the HDL code and the configuration parameters. A first HDL file may comprise a second HDL file, such as by way of the directive 'include'. The term "incomplete HDL file" concerns an HDL file lacking relevant information for simulating and/or synthesizing and/or implementing a digital design, such as at least one of: definitions (e.g., project definition, file definition, design element definition, symbol definition, etc.), declarations (e.g., library declarations and/or identifier declarations), assignments, design interconnectivity (e.g., between different modules and/or components), library mapping for instantiated symbols and/or design elements, configuration parameters, dependency or hierarchy, a directive path (e.g., include path or search path), etc. Thus, the term "complete HDL file" concerns an HDL file that includes said relevant information for simulating and/or synthesizing and/or implementing the digital design. Thus, the term "reconstructing" refers to completing an incomplete project and/or at least one incomplete HDL file comprised therein. The term "reconfiguring" refers to completing any missing configuration in an incomplete project and/or in at least one incomplete HDL file comprised therein, where the configuration may relate to at least one of: library declaration and/or library mappings, HDL level (e.g., VHDL 1987, VHDL 1993, VHDL 2001, VHDL 2008, VHDL 2019, SystemVerilog-2005, SystemVerilog-2009, SystemVerilog-2012, SystemVerilog-2017, SystemVerilog-2021, etc.), pre-processing configuration (e.g., macro definitions), HDL file dependency and/or hierarchy (e.g., use of 'include' directives and/or paths). The terms reconfiguring and reconstructing may be used interchangeably.

In this context the term "project" refers to a collection of related files and information used to at least one of: develop, simulate, synthesize, and implement a digital design. Thus, a project concerns an artefact which may be sufficient to instantiate a circuit. A project may be a file and/or may include at least one HDL file, preferably a plurality of HDL files, particularly at least one of: at least one HDL source file, at least one testbench file, and at least one configuration file. Additionally, it may include design documentation, schematics, netlists, waveforms, and other relevant data. A source file may comprise at least one design element, which may be considered as the primary design description for digital designs. A testbench file may comprise at least one of: input stimuli, initial conditions, checkpoints, assertions, and scopes and/or waveforms, which are designed to verify the functionality of a Design Unit Under Test (DUT). A configuration file may comprise specific design information to customize the behavior of a design element, such as at least one of: parameters (e.g., user-defined variables with assigned values used to modify various aspects of a design element), generics (e.g., fixed values assigned to specific design elements during compilation and simulation) and design limitations (e.g., timing requirements or power consumption limits). Therefore, the term "incomplete project" concerns a project which is lacking said relevant information in the project and/or in at least one, preferably a plurality of, incomplete HDL file(s). In embodiments, the incomplete project comprises at least one incomplete HDL file, preferably a plurality of incomplete HDL files. The missing or unspecified relevant information may be a missing or unspecified configuration file and/or may be missing or may be lacking from said configuration file. The incomplete project and/or the respective at least one, preferably a plurality of, incomplete HDL file(s) may comprise a respective configuration file which lacks said relevant information (e.g., a library declaration). Therefore, such a configuration file may be referred to as an incomplete configuration file. In embodiments, the incomplete project comprises at least one incomplete configuration file, preferably a plurality of incomplete configuration files. Therefore, the term "complete project" concerns a project that includes said relevant information in the project and/or in at least one, preferably a plurality of, complete HDL file(s). The relevant information may be a configuration file or included therein. The complete project and/or the respective at least one, preferably a plurality of, complete HDL file(s) may comprise a respective configuration file which includes said relevant information (e.g., a library declaration). Therefore, such a configuration file may be referred to as a complete configuration file. In embodiments, the complete project comprises a declaration, e.g., of at least one library. In embodiments, at least one of the complete HDL files comprises a declaration, e.g. of a library, or a plurality of declarations, e.g., of a plurality of libraries. In embodiments, a complete configuration file comprises a declaration, e.g., of a library or a plurality of declarations, e.g., of a plurality of libraries. It will be understood that the declarations of libraries may be divided among a plurality of the complete HDL files (e.g., among all the complete HDL files) and/or a plurality of the configuration files or may be included in one complete HDL file and/or one configuration file. Therefore, an incomplete or complete HDL file and/or an incomplete or complete configuration file may refer to at least one declaration, e.g., a library. In embodiments, an incomplete project consist of a plurality of incomplete HDL files. The invention is not limited to the incomplete project consisting only of incomplete HDL files and may further comprise at least one complete HDL file. Thus, the complete project may comprise a plurality of complete HDL files. The complete project may not comprise incomplete HDL files, however, the invention is not limited thereto, in that any remaining incomplete HDL file may be completed by a user.

The term "constraint" may refer to a specific condition and/or requirement that needs to be met/satisfied, e.g., when solving a satisfiability problem (SAT). Particularly, constraints refer to specific conditions and/or requirements where at least most of which, preferably all, must be met/satisfied. The constraints may comprise predicates (e.g., a function which results in a Boolean, such as String to Boolean or Integer to Boolean) and/or (logical and/or Boolean) expressions, where at least one, at least a plurality of which, preferably all of which, must be true. This ensures that the HDL files in the project can be processed correctly, making the design flow more efficient and less error prone. The constraints may relate to a name of a namespace, a name of a library, a name of a design element, a name of a symbol, type of architecture, etc.

The term "declaration" concerns a language construct configured to inform the parser and/or compiler and/or simulator and/or synthesizer about the existence, properties and characteristics of an identifier within the design. A declaration may include a keyword and a symbol thereafter, such as an identifier, and/or a design element. Examples of a declaration, particularly the keyword therein, include: an 'import' declaration, an 'entity' declaration, a 'signal' declaration, a 'variable' declaration, a 'function' declaration, a `type' declaration, a 'type alias' declaration, a 'constant' declaration, a 'procedure' declaration, a 'task' declaration, a 'port' declaration, an 'interface' declaration, a `block' declaration, a 'module' declaration, a 'parameter' declaration, a 'program' declaration, a 'covergroup' declaration, a 'clocking' declaration, a 'constraint' declaration, a 'modport' declaration, a 'class' declaration, a 'method' declaration, a 'checker' declaration, a `typedef' declaration, an 'enum' declaration, a 'sequence' declaration, etc. Thus, the step of determining constraints based on the identified at least one identifier (and the remaining identified symbols) can be more effectively performed. For example, an identifier in a declaration would typically come after a declaration keyword, such as "variable x", where x is the identifier and 'variable' is the declaration keyword. Other declarations will be known to the person skilled in the art. The declaration is not limited to including a keyword. For example, a symbol, such as an identifier and/or a design element, may be declared without using a keyword or being located thereafter, e.g., just by strating to use the symbol.

The term "reference" may refer to a language construct for instructing a parser and/or compiler and/or simulator and/or synthesizer using an identifier of, e.g. an entity or object, which has already been declared. A reference may include a keyword and a symbol thereafter, preferably an identifier, and/or a design element. The reference, particularly the keyword therein, may include at least one of: at least one directive, at least one reference statement, at least one function invocation, macro invocation, etc. A directive (e.g., 'library') and/or a reference statement (e.g., `use') may invoke a symbol, preferably an identifier therein. Examples of references include: an `include' directive, a `library' directive, a `use' statement, a 'component' statement, a 'package' statement, etc. The 'include' directive refers to including the contents of another HDL file (particularly a source file) during synthesis and/or simulation. The 'include' directive may require a directive path, i.e., an include path for searching for the identifier which is being included. The `use' statement refers to the names of symbols and/or design elements, such as packages or modules, and/or their respective namespace and/or library which will be used within an HDL file. The `library' statement may refer to the search path or directory for the netlists or compiled object files of the symbols and/or the design elements as components or modules which will be used within the design element and/or the HDL file. For example, an identifier in a reference would typically come after a reference keyword, such as "use x", where x is the identifier and 'use is the reference keyword, particularly the statement. Other declarations will be known to the person skilled in the art.

The term "directive" may refer to special instructions provided to a parser/compiler that influences the compilation process itself, rather than describing the functional behavior of the hardware design. A directive may be used to control various aspects of the compilation flow, such as including files, setting time scales, defining constants, and enabling specific warning or error modes. Typically, a directive may be preceded by or may begin with a character, such as a grave accent ''' or a hashtag '#'.

In embodiments, the method comprises determining a definition of the at least part of the project, preferably of the whole project, based on the complete HDL files. The definition may comprise at least one of: a specification and a design (architecture). The specification may comprise requirements of at least one of: functionality, behavior, inputs, outputs, constraints (e.g., performance) for the project. The design (architecture) may comprise a hierarchy of design elements and/or a hierarchy of identifiers, their interconnections, and their intended roles within the project.

In embodiments, the identified symbols comprise at least one identifier, preferably a plurality of identifiers. In embodiments, the at least one identifier, preferably the plurality of identifiers are identified in the respective HDL code based on the respective declaration introducing the respective identifier.

In embodiments, the method comprises identifying design elements in the respective HDL code, wherein the step of determining constraints is based on the identified design elements, wherein the reconstructing comprises determining a mapping of the identified design elements, preferably the incomplete HDL files, to a respective library. At least one of the identified design elements may define or comprise at least one symbol, preferably at least one identifier. The step of identifying the design elements may be based on the identified symbols, preferably identifiers.

In embodiments, the reconstructing (i.e., the reconstructing of the incomplete HDL files and/or the reconstructing of the at least part of the project), comprise (re)configuring the respective namespace and/or the respective library. A namespace and/or library (re)configuration may be stored or referred to in a respective configuration file, such as an '.xml' file. In preferred embodiments, the mapping of at least one of: the identified symbols (preferably identifiers), the identified design elements, and the incomplete HDL files, to a respective namespace and/or to a respective library (re)configures the respective namespace and/or the respective library.

In embodiments, the step of identifying symbols (preferably identifying identifiers) and/or the step of identifying design elements comprises performing linting. The linting may comprise analyzing the syntactical and structural correctness of the respective HDL code. The linting may comprise comparing the respective HDL code to a set of rules or guidelines, looking for potential errors, inconsistencies, or design issues that could lead to incorrect behavior or make the respective HDL code more difficult to understand, maintain, or verify.

In embodiments, the step of identifying symbols, preferably identifiers, and/or the step of identifying design elements, comprises identifying respective references in the respective HDL code. In embodiments, the identified symbols, preferably identifiers, and/or the identified design elements may be comprised in the reference, preferably after the keyword in the reference.

In embodiments, the step of identifying symbols, preferably identifiers, and/or the step of identifying design elements, comprises identifying respective declarations in the respective HDL code. In embodiments, the identified symbols, preferably identifiers, and/or the identified design elements may be comprised in the declaration, preferably after the keyword in the declaration. In particularly advantageous embodiments, the method, preferably the step of determining constraints comprises determining a dependency between the incomplete HDL files based on the identified symbols (preferably identifiers) and/or design elements. Thus, the reconstructing or the reconfiguring of the incomplete HDL files (or of the incomplete project) may be based on the determined dependency between the incomplete HDL files, particularly, the step of determining a mapping may be based on the determined dependency between the incomplete HDL files. The determining a dependency between the incomplete HDL files may comprise determining a dependency between the incomplete HDL files and other HDL files (e.g., other complete HDL files) in the project. Thus, the reconstructing or the reconfiguring of the incomplete HDL files (or of the incomplete project) may be based on the determined dependency between the incomplete HDL files and the other HDL files, particularly, the step of determining a mapping may be based on the determined dependency between the incomplete HDL files and the other HDL files.

In embodiments, the incomplete HDL files comprise a first incomplete HDL file and a second incomplete HDL file, wherein the first incomplete HDL file comprises a first HDL code, and wherein the second incomplete HDL file comprises a second HDL code.

In particularly advantageous embodiments, the method, preferably the step of determining constraints comprises determining a dependency between the identified symbols, particularly the identified identifiers. The dependency between the identified symbols may comprise determining a hierarchy between the identified symbols, particularly the identified identifiers. The dependency between the identified symbols may comprise an interconnectivity between the identified symbols. Thus, the reconstructing may be based on the determined dependency between the identified symbols, particularly, the step of determining a mapping may be based on the determined dependency between the identified symbols.

In particularly advantageous embodiments, the method, preferably the step of determining constraints comprises determining a dependency between the identified design elements. The dependency between the identified design elements may comprise determining a hierarchy between the identified design elements. The dependency between the identified design elements may comprise an interconnectivity between the identified design elements. Thus, the reconstructing may be based on the determined dependency between the identified design elements, particularly, the step of determining a mapping may be based on the determined dependency between the identified design elements.

In further advantageous embodiments, the method, preferably the step of determining constraints comprises determining a dependency between the identified symbols and the identified design elements. The dependency between the identified symbols and the identified design elements may comprise determining a hierarchy between the identified symbols and the identified design elements. The dependency between the identified symbols and the identified design elements may comprise an interconnectivity between the identified symbols and the identified design elements. Thus, the reconstructing may be based on the determined dependency between the identified symbols and the identified design elements, particularly, the step of determining a mapping may be based on the determined dependency between the identified symbols and the identified design elements.

In embodiments, the step of determining constraints comprises determining the dependency between the incomplete HDL files based on at least one of the identified identifiers, the identified directives, and the identified design elements. In embodiments, where the identified directives are not used to identify the identifiers and/or the design elements, then the determining the dependency between the incomplete HDL files may be based on at least the identified directives.

In embodiments, the step of determining a dependency comprises detecting a match between (i.e., matching) the identified symbols and/or between the identified design elements, preferably linking the matches. For example, matching entities links a component declaration of an instantiation to the matching entity declaration. This can also be understood for component generics and ports. In another example, matching modules links a component declaration of an instantiation to the matching (Verilog) module declaration. Modules that are instantiated as entity instantiations may also be supported (e.g., label: entity work.verilogmodule port map (...);). Other examples include matching architecture for entity declarations and matching 'when' clauses. For example, in the following HDL code (use entity XCoreLib.C_DA_2D_V2_0(behavioral)), the directives are identified as the `use' statement and 'entity' statement, the reference is identified as referring to a C_DA_2D_DCT_V2_0 (discrete cosine transform) entity with an identified architecture being behavioral, and the dependency is determined that the entity is declared in a library XCoreLib which is used (e.g., in another file) and which can be identified based on the directive 'library' and based on the library name.

In embodiments, the identified symbols (e.g., identifier) comprise a first symbol (e.g. first identifier) declared in the first HDL file, particularly first HDL code, and wherein the first symbol is used in the second HDL file, particularly second HDL code. For instance, the first HDL code declares an entity, via an 'entity' declaration, as "entity entity_example", and the second HDL code uses the a particular package that contains the entity declaration, via a `use' statement, as "use work.function_example". Thus, it can be determined that the use of a symbol, in this instance a design element (particularly a package), in the second incomplete HDL file depends on the declaration of the symbol, in this instance an entity which includes the design element (particularly the package), in the first incomplete HDL file, and thus, the second incomplete HDL file depends on the first incomplete HDL file based on the first symbol.

The second incomplete HDL file may include the first incomplete HDL file or the contents thereof. For instance, an `include' statement is used in the second HDL code to treat the included first incomplete HDL file as if its contents were written directly into the second incomplete HDL file at the location of the 'include' directive. Therefore, based on the directive and/or the respective identifier it can be determined in that a configuration, particularly, the directive path (e.g., the include path) needs to be reconfigured (or adjusted) such that the directive can find the included first HDL file. Thus, it can be determined that the second incomplete HDL file depends on the first incomplete HDL file based on the direct inclusion of the first incomplete HDL file in the second incomplete HDL file.

In embodiments, the dependency comprises a hierarchy, such as an ordering or a nested configuration, of the incomplete HDL files. For instance, the first symbol is declared in the first HDL code and used in the second HDL code, then it can be determined that the first incomplete HDL file is a higher-level file compared to the second incomplete HDL file, i.e., the first incomplete HDL file is to be processed (e.g., during compilation) before the second incomplete HDL file. The level of the HDL file may depend on the type of hierarchy, i.e., when looking at the circuit structure, a parent component is ranked or ordering at a lower-level in hierarchy than a sub-component.

Such embodiments may advantageously further improve the reconstructing or the reconfiguring of the incomplete HDL files (or of the incomplete project) of the incomplete HDL files by including the dependency, preferably the ordering, of the HDL files and/or the dependency, preferably the hierarchy, of the identified symbols and/or design elements as constraints. This is particularly advantageous when determining the mapping of the identified symbols and/or the identified design elements, preferably of the incomplete HDL files. By improving the determining of the constraints, said mapping can be more efficiently and effectively determined, and as a result, the reconstructing and/or reconfiguring of the incomplete HDL files for simulating and/or implementing the circuit can be more reliably performed. For example, (System) Verilog files are stateful, and therefore, do not reset after each file is opened/processed by a pre-processor. Therefore, the determining an ordering of said files can improve determining of (at least part of) a project. The ordering can allow for speedier determination of constraints, and as a result faster reconstruction of the incomplete HDL files.

In embodiments, the steps of identifying (i.e., identifying identifiers and/or design elements and/or references) and/or the step of determining constraints may be performed in real-time. Thus, the constraints may be adapted based on the real-time identification of identifiers and/or design elements and/or references. This can provide the user with real-time feedback of what has been identified and which constraints have been determined. Thus, the user may for instance decide to adapt the respective HDL code if an error or warning has been identified, and the user would not have to wait for the simulation of the project or for the identification to be performed in all the incomplete HDL files. In preferred embodiments, the step of determining constraints is performed after all the identifiers and/or design elements and/or references have been identified. This can ensure that the step of determining constraints is performed once and is based on all the relevant identified information.

In embodiments, the first incomplete HDL file comprises a first HDL code written in a first HDL, and the second incomplete HDL file comprises a second HDL code written in a second HDL. The first and second HDLs may be different, such as the first HDL being VHDL and the second HDL being Verilog. It will be understood that the respective complete HDL files are written in the respective HDL, i.e., the first complete HDL file is written in the first HDL and the second complete HDL is written in the second HDL.

In embodiments, the mapping relates to solving a satisfiability (SAT) problem to satisfy at least most of the constraints, preferably all the determined constraints. The SAT problem may be used as part of the process for designing and verifying physical designs represented by logical and/or Boolean expressions (e.g., formulas). For example, SAT solvers can be employed to verify that a given logical design meets certain (functional and/or logical) requirements before building a physical prototype of the design, e.g., a physical circuit. Thus, the SAT problem can be viewed as a type of (mathematical) modelling of (digital logic design) projects, where the objective is to find an assignment of variables that satisfies constraints (i.e., logical and/or Boolean expressions).

The SAT problem may be solved by means of a SAT solver, such as a backtracking algorithm, which is a Depth-First Search (DFS)-based algorithmic technique. An example of using a backtracking algorithm includes the following steps: initializing all variables to false by default, selecting an unassigned variable x and try assigning it values true and false, one at a time (for each assignment, performing Unit Propagation (Unit Clause Resolution) to eliminate redundant assignments and propagate implications, if all clauses are satisfied or no unassigned variables left, then the current assignment is a solution, however, if a variable cannot be assigned without violating any clause, then backtracking and trying another value for that variable, repeating this process until either a satisfying assignment is found or all possible combinations have been tried.

Alternative means for solving the SAT problem may include any of a Davis-Putnam logic-based method, conflict-driven clause learning, Boolean solvers using sparse matrix technique, integer linear programming (ILP) formulation, constraint programming (CP) technique. The Davis-Putnam logic-based method may comprise repeatedly applying unit propagation, pure literal elimination, and unit clause resolution to eliminate tautologies (true statements) and contradictions (false statements). The conflict-driven clause learning may, whenever a conflict is detected (i.e., an assignment violates multiple clauses), learn a new clause from the conflict and used to guide the search. The Boolean solvers using sparse matrix technique may convert the problem into a system of linear equations, which are solved using various iterative methods such as Gaussian elimination or the Davis-Putnam procedure. The ILP formulation may convert the SAT problem into an ILP problem by introducing binary variables and encoding Boolean formulas using linear inequalities. The CP technique may use constraints on variable domains to describe the problem and search for solutions using various techniques such as forward checking, backtracking, and constraint propagation.

In preferred embodiments, the satisfiability (SAT) problem is solved by means of a Satisfiability Modulo Theories (SMT) solver. The SMT may handle quantifier-free formulas involving multiple theories, which extends the functionality of a SAT solver by allowing reasoning with theories beyond just Boolean logic, such as linear integer arithmetic, arrays, bit vectors, and uninterpreted functions. It can be seen as a combination of a SAT solver and an Automated Theorem Prover (ATP).

In more preferred embodiments, the satisfiability (SAT) problem is solved by means of a combination of the SMT solver and the SAT solver (e.g., backtracking algorithm).

In embodiments, the determined constraints are stored in a constraints file. Said constraints file may be used to reconstruct the incomplete HDL files to obtain complete HDL files. The constraints file may be provided to a SAT and/or SMT solver for solving the SAT problem to satisfy at least most, preferably all, the constraints in the constraints file.

In embodiments, the mapping relates to solving a Constraint Satisfaction Problem (CSP) to satisfy at least most of the constraints, preferably all the determined constraints. In a CSP, instead of dealing with Boolean formulas, there are a set of variables, domains for each variable, and constraints between variables, wherein the goal is to find an assignment of values to the variables that satisfies at least most of the constraints, preferably all the determined constraints.

In embodiments, the solving of a CSP is performed by means of a CSP solver. Compared to a SAT solver, a CSP solver can handle a wider range of constraint types, including arithmetic, linear, quadratic, and equality constraints. Examples of a CSP solver include: a forward checking and arc consistency algorithm (AC-3), a unit propagation algorithm, a backtracking search algorithm, local search algorithm, etc.

In embodiments, the method comprises detecting a respective value of at least one of the identified symbols, particularly of at least one of the identified identifiers, such as at least one constant or macro.

In embodiments, the method comprises identifying that there is missing information for mapping all the incomplete HDL files, preferably notifying a user of the missing information, and more preferably obtaining said information from the user, wherein the reconstructing and/or reconfiguring are/is based on the obtained information. In embodiments, the method comprises identifying that a respective value for at least one of the identified symbols, particularly for at least one of the identified identifiers, and/or for at least one of the identified design elements is missing notifying a user of the at least one of the identified identifiers, and obtaining said respective value from the user, wherein the reconstructing and/or reconfiguring are/is based on the obtained respective value. The method may further comprise, upon identifying that the respective value is missing, notifying a user of the at least one of the identified symbols, particularly for at least one of the identified identifiers, and/or of the missing respective value thereof. The method may further comprise obtaining, from the user, the respective value of the at least one of the identified symbols, particularly for at least one of the identified identifiers. In preferred embodiments, the step of reconstructing and/or reconfiguring are/is based on the obtained respective value of the at least one of the identified symbols, particularly for at least one of the identified identifiers. The user may be notified and may provide the respective information and/or respective values via a graphical user interface (GUI).

In embodiments, the method comprises generating a graphical representation of the at least one of the identified symbols, particularly for at least one of the identified identifiers, and/or of the at least one design element, for which the respective value is missing. The graphical representation may include the determined dependency, such as the determined hierarchy and/or the determined link, of the at least one of the identified symbols, particularly for at least one of the identified identifiers, and/or of the at least one design element. By doing so, the user can more easily understand of which the at least one of the identified symbols, particularly for at least one of the identified identifiers, and/or of the at least one design element is missing a respective value and to provide the respective missing value more effectively.

In embodiments, the method comprises pre-processing the respective HDL code (e.g., by a pre-processor). The pre-processing may comprise the step of determining a dependency between the incomplete HDL files and preferably between all the HDL files in the incomplete project. For example, Verilog files are pre-processed to determine their ordering before reconfiguring of the Verilog files is performed. This may be highly relevant to more effectively compile (System) Verilog files, since the order of the files may be needed in advance. The pre-processing may comprise the step of identifying that a respective value is missing for at least one of the identified identifiers. The pre-processing may comprise (textually) expanding at least one of the identified symbols, particularly at least one of the identified identifiers, such as at least one macro, which may refer to replacing a macro call (i.e., the instance of the macro name) with its corresponding expanded code in the source file during compilation. The pre-processing may comprise (textually) expanding at least one of the identified symbols, particularly at least one of the identified identifiers, such as at least one module. For example, an 'adder' module is defined that performs bitwise addition of two buses. An 'adders_array' module is created with a 'generate' statement to instantiate multiple instances of the 'adder' module based on a loop and parameter values for a width and number of adders in the array. So, when synthesizing, the necessary text for each instantiation of the 'adder' module will be generated within the 'adders_array' module. The resulting HDL code will contain separate instances of the addition logic for each adder, making it easier to understand and debug individual components while still retaining the reusability and modularity of the project. This further allows for more effective determination of the constraints. The pre-processing may comprise substituting the contents of the respective element, such an HDL file, after at least one 'include' statement in each incomplete HDL file, preferably in each HDL file comprised in the project, where said at least one 'include' statement is identified. The pre-processing may comprise defining at least one of the identified symbols, such as a constant, e.g., a debug flag is assigned a Boolean value, or a bit width is assigned an integer value. The step of defining may comprise substituting the respective definition of said at least one of the identified symbols in each incomplete HDL file, preferably in each HDL file comprised in the project, where said at least one symbol is identified. The respective definition of said at least one of the identified symbols may comprise the detected respective value of at least one of the identified symbols, particularly of at least one of the identified identifiers, such as at least one constant or macro. Additionally or alternatively, the respective definition of said at least one of the identified symbols may comprise the obtained respective value of at least one of the identified symbols, particularly of at least one of the identified identifiers.

In embodiments, the method comprises manufacturing a circuit design based on the complete HDL files, preferably based on the complete project. In embodiments, the method comprises manufacturing a circuit design based on the simulated circuit.

In embodiments, the system further comprises manufacturing means configured to manufacture a (digital and/or circuit) design based on the complete HDL files, preferably based on the complete project and/or based on the simulated circuit. This can allow for improved manufacturing of the digital circuit and/or the integrated circuit based on the digital design, preferably the complete project and/or the simulated circuit.

In embodiments, the user apparatus comprises a graphical user interface (GUI), allowing the user to provide to the device the incomplete HDL files, preferably the complete project and/or the simulated circuit. Furthermore, the GUI may allow the user to provide any missing information requested or required by the device, such as the respective value of the at least one of the identified symbols, particularly for at least one of the identified identifiers.

### Examples

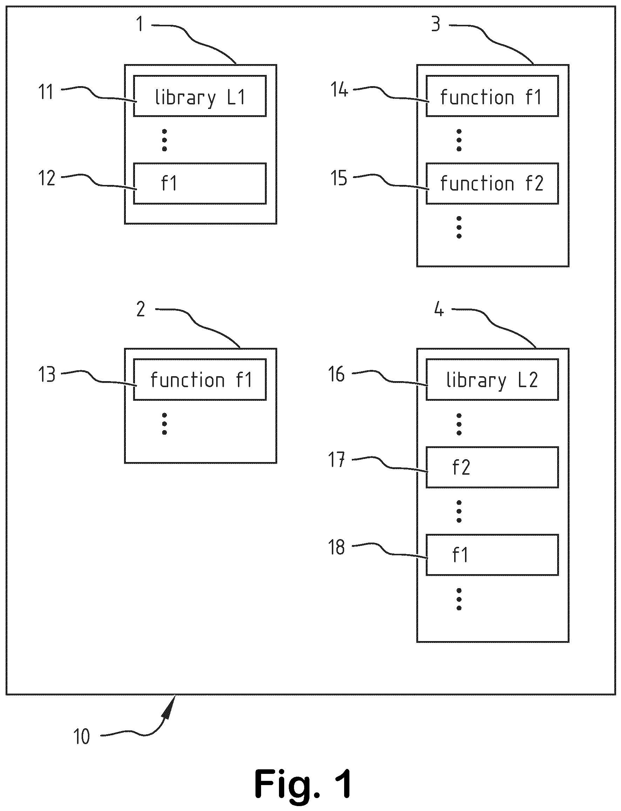

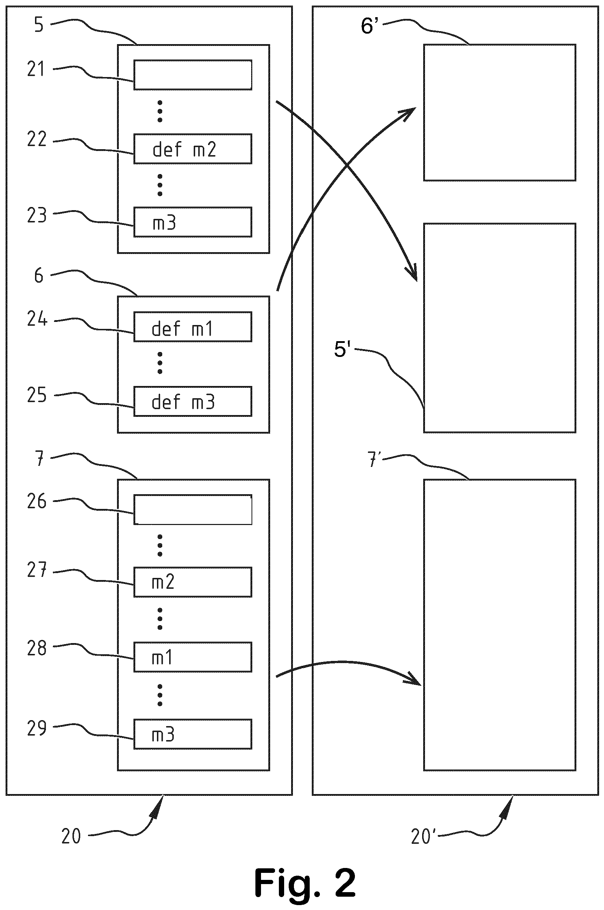

Example embodiments of the invention will be described with reference to Fig. 1 and 2, which are not intended to limit the scope of the invention in any way.

### Example 1: example of a method according to the invention

This example is described with reference to Fig. 1. In this example according to embodiments of the invention, there is provided a method of reconfiguring an incomplete project (10) for implementation of a circuit into a complete project for implementation of the circuit, the incomplete project comprising incomplete HDL files (1-4) and the complete project comprising complete HDL files. The method comprises obtaining the incomplete HDL files (1-4). In this example, the respective HDL code in the incomplete HDL files (1-4) is written in the same HDL, particularly VHDL. Thus, the incomplete HDL files (1-4) will be referred to herein as 1.vhd, 2.vhd, 3.vhd and 4.vhd, respectively.

The method comprises identifying identifiers, declarations and references, particularly directives and function invocations in the respective HDL code in the incomplete HDL files (1-4). Here, the identifying of identifiers is based on the identification of the declarations and the references. The identifiers are identified as follows:
- a 'library' statement is identified as a reference, particularly a statement (11) in the incomplete HDL file (1) named 1.vhd, and `L1' is identified in 1.vhd as an identifier, particularly a library `L1' based on the identified statement (11), where the library `L1' is invoked in 1.vhd.
- an invocation of 'f1' is identified as a reference, particularly a function invocation (12) of `f1' which is identified as an identifier, particularly a function `f1', based on the identified function invocation (12) in 1.vhd.
- a 'function' declaration is identified as a function declaration (13) in the incomplete HDL file (2) named 2.vhd, and `f1' is identified in 2.vhd as an identifier, particularly a function `f1' based on the identified function declaration (13), where the function 'f1' is declared in the 2.vhd.
- a 'function' declaration is identified as a function declaration (14) in the incomplete HDL file (3) named 3.vhd, and `f1' is identified in 3.vhd as an identifier, particularly a function `f1' based on the identified function declaration (14), where the function 'f1' is declared in 3.vhd.
- a 'function' declaration is identified as a function declaration (15) in 3.vhd, and `f2' is identified in 3.vhd as an identifier, particularly a function `f2' based on the identified function declaration (15), where the function `f2' is declared in 3.vhd.
- a `library' statement is identified as a reference, particularly a statement (16) in the incomplete HDL file (4) named 4.vhd, and `L2' is identified in 4.vhd as an identifier, particularly a library `L2' based on the identified statement (16), where the library `L2' is invoked in 4.vhd.
- an invocation of 'f2' is identified as a reference, particularly a function invocation (17) of 'f2' which is identified as an identifier, particularly a function 'f2', based on the identified function invocation (17) in 4.vhd.
- an invocation of `f1' is identified as a reference, particularly a function invocation (18) of `f1' which is identified as an identifier, particularly a function `f1', based on the identified function invocation (18) in 4.vhd.

The method comprises determining constraints which is based on the identified identifiers, declarations and references (in this case particularly library statements and function declarations). The constraints are determined as follows:
- a first constraint: it is determined that the identifier 'f1', i.e., the function `f1', must be obtained from outside of 1.vhd which is dependent on another file that declares the function `f1'. Thus, the function declaration of function `f1' and the file that includes the definition or declaration of function `f1' must be included or instantiated in the library 'L1', since library 'L1' is referenced or invoked (11) in 1.vhd.
- a second constraint: it is determined that both 2.vhd and 3.vhd declare the function `f1', therefore, exactly one of 2.vhd and 3.vhd must be included or instantiated in the library `L1'.
- a third constraint: 4.vhd has no declarations of the functions `f1' and `f2', thus, both functions `f1' and `f2' must be obtained from outside of 4.vhd which is dependent on another file that declares the functions `f1' and `f2'. Thus, the declarations of functions `f1' and `f2', as well as the file that includes said declarations must be included or instantiated in the library `L2', since library `L2' is referenced or invoked (16) in 4.vhd.

The method comprises reconstructing the incomplete HDL files (1-4) based on the constraints to obtain complete HDL files, wherein the reconstructing and/or reconfiguring comprises determining a mapping of the incomplete HDL files (1-4) to a respective library. The mapping may include mapping the respective identifiers, preferably also the references and the declarations in the incomplete HDL files (1-4) to a respective library. The step of determining constraints comprises determining a dependency between the incomplete HDL files (1-4), as follows:
- a first dependency: it is determined that since 4.vhd invokes functions `f1' and `f2' (17, 18), and since 3.vhd declares functions `f1' and `f2' (14, 15), then 4.vhd is dependent on 3.vhd.
- a second dependency: it is determined that since 1.vhd invokes functions 'f1' (12), and since 2.vhd declares function `f1' (13) and that 3.vhd also declares function `f1' (14), then 1.vhd may be dependent on 2.vhd and/or 3.vhd.

The mapping can be determined as follows:
- a first mapping: it is determined that since 4.vhd is dependent on 3.vhd, uses library `L2', and invokes functions `f1' and `f2', then 4.vhd is dependent on the declarations (14) thereof in 3.vhd and that 3.vhd is mapped to library `L2'.
- a second mapping: it is determined that since 1.vhd uses library `L1' and that library `L1' must contain function 'f1' and/or the declaration thereof which cannot come from file 3.vhd, since 3.vhd has already been determined to be in or mapped to library `L2', then function 'f1' (12) and/or the declaration (13) thereof must come from library `L2' which is the only remaining file with a declaration of function `f1'. Hence, it is determined that 2.vhd is mapped to library `L1'
- other mappings: it may be approximated that 1.vhd are mapped to library `L1' and 4.vhd is mapped to library `L2'. However, the incomplete (10) is an under-constrained project, and the mapping of 1.vhd and 4.vhd may be determined by obtaining from a user an input (e.g., additional information relating to the mappings of the files 1.vhd and 4.vhd).

Thus, every incomplete HDL file (1-4) can be mapped to a library. However, the other mappings may not be necessary since both files (1, 4) do not define or declare an identifier or a design element. Moreover, by identifying the identifiers (e.g., based on the respective identified directives, function invocations and declarations) and by determining the dependency of the incomplete HDL files, preferably also the identifiers, more preferably the declarations and references, declared and/or invoked therein, the constraints are more effectively determined, and thus, the mapping of the respective files, preferably also the identifiers, more preferably the references and the declarations, declared and/or invoked therein to the respective library can be more accurately done. This, results in a more effective and accurate reconstruction and/or reconfiguration of the incomplete HDL files (1-4) and/or reconstruction and/or reconfiguration of the incomplete project (10) for implementation of the circuit.

### Example 2: example of a method according to the invention

This example is described with reference to Fig. 2. In this example according to embodiments of the invention, there is provided a method of reconfiguring an incomplete project (20) for implementation of a circuit into a complete project for implementation of the circuit, wherein the method comprises pre-processing the incomplete HDL files.

The incomplete project comprises incomplete HDL files (5-7) and the complete project comprising complete HDL files. The method comprises obtaining the incomplete HDL files (5-7). In this example, the respective HDL codes in the respective incomplete HDL files (5-7) are written in the same HDL, particularly System Verilog. Thus, the incomplete HDL files (5-7) will be referred to herein as 5.sv, 6.sv, and 7.sv, respectively.

The method comprises identifying identifiers, declarations and references, particularly directives and macro invocations in the respective HDL code in the incomplete HDL files (5-7). The identifiers are identified as follows:
- a declaration (21) is identified in the incomplete HDL file (5) named 5.sv. For example, a first package (directory) is identified as an identifier based on the identified declaration (21), where the content(s) of the first package is imported in 5.sv.
- a 'def' declaration is identified as a declaration (22) in 5.sv, and 'm2' is identified in 5.sv as an identifier, particularly a macro 'm2' based on the identified declaration (22), where the macro 'm2' is declared in 5.sv.
- an invocation of 'm3' is identified in 5.sv as a reference, particularly a macro invocation (23) of 'm3' which is identified as an identifier, particularly a macro 'm3' based on the identified macro invocation (23) in 5.sv.
- a 'def' declaration is identified as a declaration (24) in the incomplete HDL file (6) named 6.sv, and `m1' is identified in 6.sv as an identifier, particularly a macro `m1' based on the identified declaration (24), where the macro `m1' is declared in 6.sv.
- a 'def' declaration is identified as a declaration (25) in 6.sv, and 'm3' is identified in 6.sv as an identifier, particularly a macro 'm3' based on the identified declaration (25), where the macro 'm3' is declared in 6.sv.
- an 'import' declaration is identified as a declaration (26) in the incomplete HDL file (7) named 7.sv. For example, a second package is identified as an identifier based on the identified declaration (26), where the content(s) of the second package is imported in 7.sv.
- an invocation of 'm2' is identified in 7.sv as a reference, particularly a macro invocation (27) of 'm2' which is identified as an identifier, particularly a macro 'm2' based on the identified macro invocation (27) in 7.sv.
- an invocation of `m1' is identified in 7.sv as a reference, particularly a macro invocation (28) of 'm1' which is identified as an identifier, particularly a macro `m1' based on the identified macro invocation (28) in 7.sv.
- an invocation of 'm3' is identified in 7.sv as a reference, particularly a macro invocation (29) of 'm3' which is identified as an identifier, particularly a macro 'm3' based on the identified macro invocation (29) in 7.sv.

The pre-processing comprises textually expanding the identified macros including macros 'm1', 'm2' and 'm3' in the incomplete HDL files (5-7) to obtain an expanded incomplete HDL file (5'), an expanded incomplete HDL file (6') and an expanded incomplete HDL file (7') comprised in an expanded part of an incomplete project (20'), herein referred to as 5'.sv, 6'.sv and 7'.sv respectively.

The method comprises determining constraints comprising determining a dependency between the incomplete HDL files (5-7), as follows:
- a first dependency: it is determined that 5.sv is dependent on 6.sv, since it is determined that the identifier 'm3' and/or the macro invocation (23) of the macro 'm3' in 5.sv are/is dependent on the definition of macro 'm3' in 6.sv.
- a second dependency: it is determined that 7.sv is dependent on 5.sv and 6.sv, since it is determined that the identifiers `m1' and 'm3', particularly the macros `m1' and 'm3' and/or the macro invocations (28, 29) of macros `m1' and 'm3' in 7.sv are dependent on the declarations (24, 25) thereof in 6.sv, and the identifier 'm2' and/or the macro invocation (27) of macro 'm2' in 7.sv are/is dependent on the declaration (22) thereof in 5.sv.

As can be seen in Fig. 2, the dependency comprises an ordering of the expanded HDL files (5'-7'), wherein 7'.sv is after 5'.sv which is after 6'.sv in the order.

Thus, the processing of the files to perform the steps of determining constraints and determining a mapping may be performed in this determined order.

Note that, in this example, the declarations (21, 26) do not influence the pre-processing, particularly the dependency, particularly the ordering, of the HDL files (5'-7'). Thus, the declarations (21, 26) in this example are non-limiting.

### (End of Example 2)

The above-described inventive concepts are illustrated by several illustrative embodiments. It is conceivable that individual inventive concepts may be applied without, in so doing, also applying other details of the described example. It is not necessary to elaborate on examples of all conceivable combinations of the above-described inventive concepts, as a person skilled in the art will understand numerous inventive concepts can be (re)combined in order to arrive at a specific application.

Although the present invention has been described above with reference to certain embodiments thereof, it will be evident that various modifications and changes may be made to these embodiments without departing from the broader scope of the present invention, as defined by the appended claims.

## Claims

1. A computer-implemented method of reconfiguring an incomplete project for implementation of a circuit into a complete project for implementation of the circuit, the incomplete project comprising incomplete hardware description language, HDL, files, the complete project comprising complete HDL files, the method comprising:
- obtaining the incomplete HDL files comprising a respective HDL code,
- identifying identifiers in the respective HDL code,
- determining constraints based on the identified identifiers, and
- reconfiguring the incomplete HDL files based on the constraints to obtain the complete HDL files,
wherein the reconfiguring of the incomplete HDL files comprises determining a mapping of the incomplete HDL files to a respective library,
wherein the mapping relates to solving a satisfiability problem to satisfy the constraints.

2. The method according to any of claim 1, further comprising generating instructions for manufacturing the circuit based on the complete project, wherein said manufacturing preferably relates to producing of an ASIC or to programming of an FPGA.

3. The method according to claim 1 or claim 2, further comprising identifying references in the respective HDL code, wherein the step of identifying identifiers is based on the identified references, respectively, and
preferably further comprising identifying declarations in the respective HDL code, wherein the step of identifying identifiers is based on the identified declarations, respectively.

4. The method according to any of claims 1-3, further comprising identifying design elements in the respective HDL code, wherein the step of determining constraints is further based on the identified design elements,
preferably wherein the step of identifying design elements is based on at least one of the identified identifiers, the identified references, and the identified declarations, respectively.

5. The method according to any of claims 1-4, wherein the step of determining constraints comprises determining a dependency between the incomplete HDL files based on at least one of the identified identifiers, the identified references, the identified declarations, and the identified design elements.

6. The method according to claim 5, wherein the dependency relates to a hierarchy of the incomplete HDL files.

7. The method according to any of claims 1-6, wherein the satisfiability problem is solved by means of a backtracking algorithm.

8. The method according to any of claims 1-7, wherein the complete project comprises declarations of libraries, preferably wherein at least one of the complete HDL files comprises the declarations of libraries.

9. The method according to any one of claims 1-8, wherein the incomplete HDL files comprise a first incomplete HDL file and a second incomplete HDL file, wherein the first incomplete HDL file comprises a first HDL code written in a first HDL, and wherein the second incomplete HDL file comprises a second HDL code written in a second HDL,
wherein at least one of the identified identifiers is declared in the first HDL code and is referenced in the second HDL code.

10. The method according to any of claims 1-9, further comprising pre-processing the incomplete HDL files, wherein the pre-processing comprises at least one of: expanding at least one identified macro in the respective HDL code, substituting the contents of at least one source file included in the respective HDL code, and substituting a definition of at least one identified constant included in the HDL code.

11. The method according to any of claims 1-10, further comprising upon identifying that a respective value is missing for at least one of the identified identifiers, notifying a user of the missing respective value, and obtaining said respective value from the user, wherein the reconfiguring of the incomplete HDL files is based on the obtained respective value.

12. A device comprising means for carrying out the method of any one of claims 1-11.

13. A system comprising:
a device according to claim 12; and
a user apparatus comprising a display and being connected to the device,
wherein the device is configured to perform the steps of:
- obtaining, from the user apparatus, the incomplete HDL files comprising a respective HDL code,
- identifying identifiers in the respective HDL code,
- determining constraints based on the identified identifiers, and
- reconfiguring the incomplete HDL files based on the constraints to obtain the complete HDL files,
wherein the reconstructing of the incomplete files comprises determining a mapping of the incomplete HDL files to a respective library,
wherein the mapping relates to solving a satisfiability problem to satisfy the constraints,
wherein the user apparatus is configured to perform the following steps:
- providing, to the device, the incomplete HDL files comprising a respective HDL code, and
- obtaining, from the device, the complete HDL files.

14. A computer program comprising instructions which, when the program is executed by a computer, cause the computer to carry out the method of any one of claims 1-11.

15. A computer-readable medium comprising instructions which, when executed by a computer, cause the computer to carry out the method of any one of claims 1-11.
